# FASCICULE DE BREVET EUROPEEN

(11) **EP 2 826 076 B1**
(45) Date de publication et mention de la délivrance du brevet: **20.04.2016**
(21) Numéro de dépôt: 13719890.9
(22) Date de dépôt: 12.03.2013
(51) Int. Cl.: H01L 31/055, H01L 31/048, H01L 31/0232

(54) **MODULE PHOTOVOLTAÏQUE COMPRENANT UN ÉLÉMENT DE CONVERSION SPECTRALE LOCALISÉ ET PROCÉDÉ DE RÉALISATION.**
PV-MODUL MIT EINEM LOKALISIERTEN SPEKTRALEN UMWANDLUNGSELEMENT UND HERSTELLUNGSVERFAHREN
PHOTOVOLTAIC MODULE COMPRISING A LOCALISED SPECTRAL CONVERSION ELEMENT AND PRODUCTION PROCESS

(30) Priorité: 13.03.2012 FR 1200760
(43) Date de publication de la demande: 21.01.2015
(73) Titulaire: Commissariat à l'Énergie Atomique et aux Énergies Alternatives, 75015 Paris (FR)
(72) Inventeur: LE PERCHEC, Jérôme, F-38000 Grenoble (FR); VOARINO, Philippe, F-06000 Nice (FR)
(74) Mandataire: Talbot, Alexandre
(86) Numéro de dépôt international: PCT/FR2013/000065
(87) Numéro de publication internationale: WO 2013/135980

(56) Documents cités:
- EP-A1- 2 372 786
- WO-A2-2011/082806
- DE-U1-202009 007 771
- GB-A- 2 474 292
- US-A1- 2009 095 341
- US-A1- 2010 180 932

## Description

### Domaine technique de l'invention

L'invention est relative à un module photovoltaïque pour convertir un rayonnement électromagnétique incident en énergie électrique, et à un procédé de réalisation d'un tel module photovoltaïque.

### État de la technique

Un module photovoltaïque comprend classiquement une plaque avant et une plaque arrière, entre lesquelles sont interposées une ou plusieurs cellules photovoltaïques connectées électriquement entre elles, ainsi qu'un matériau d'encapsulation dans lequel sont noyées la ou les cellules.

Un des principaux enjeux dans le domaine des modules photovoltaïques est d'augmenter le rendement de conversion photovoltaïque, appelé ci-après rendement de conversion, ou de rendre le module plus efficace lorsqu'il est soumis à une lumière diffuse (conditions nuageuses).

Une première approche pour répondre à ces besoins est d'utiliser un réflecteur, disposé sur la plaque arrière du module photovoltaïque, afin de rediriger la lumière incidente vers les cellules du module.
Par exemple, le brevet US 6,410,843 et la demande internationale WO 99/56317 proposent de mettre en place un dispositif réflecteur sur la plaque arrière pour réfléchir la lumière incidente vers la face arrière des cellules. De plus, la surface interne de la plaque arrière est structurée sous forme de motifs diffractants, avec par exemple une structure pyramidale. La surface structurée est alors recouverte par un revêtement réflecteur, par exemple à base d'aluminium ou d'argent. Dans ce cas, les espaces entre les cellules adjacentes permettent de laisser passer le rayonnement électromagnétique incident jusqu'à la plaque arrière du module photovoltaïque, où il est réfléchi par le réflecteur et redirigé sur la face arrière desdites cellules.
La demande de brevet US 2009/0178704 décrit l'utilisation d'une plaque arrière recouverte d'un réflecteur ayant une structure pyramidale. Elle décrit également l'utilisation de particules métalliques enveloppées dans un film plastique recouvrant le réflecteur et utilisées pour diffuser la lumière.
Ces configurations de module photovoltaïque utilisant une surface réfléchissante et structurée sous forme pyramidale nécessitent cependant des techniques de dépôt précises et coûteuses. En effet, d'une part l'angle des pyramides de la surface texturée doit avoir une valeur précise afin de pouvoir réfléchir correctement les rayons incidents et d'autre part, les matériaux utilisés pour le revêtement sont coûteux.

Pour augmenter le rendement de conversion des modules photovoltaïques, une autre approche consiste à modifier une partie du spectre solaire effectivement perçu par les cellules.

Par exemple, la demande internationale WO2008/110567, propose de modifier une partie du spectre solaire effectivement perçu par les cellules en disposant des espèces luminescentes (dites éléments de conversion spectrale) dans le milieu d'encapsulation situé entre la plaque avant du module et lesdites cellules. Un tel milieu d'encapsulation recouvre complètement la face avant des cellules photovoltaïques et éventuellement leur face arrière.

La demande de brevet US 2009/0095341 décrit également un module photovoltaïque où les cellules photovoltaïques sont entièrement recouvertes par une couche contenant les éléments de conversion spectrale.

Les éléments de conversion spectrale classiquement utilisés sont des espèces luminescentes capables d'absorber au moins partiellement les photons arrivant dans le milieu d'encapsulation et de les réémettre à des longueurs d'onde différentes, notamment, plus élevées.

De nombreux éléments de conversion spectrale peuvent encore être utilisés, il peut s'agir de matériaux fluorescents organiques et inorganiques (DE 20 2009 007771) ou encore de matériaux semi-conducteurs (US 2010/0180932). Cependant, les matériaux luminescents ont le plus souvent un rendement quantique inférieur à un. Ainsi, les matériaux à conversion spectrale absorbent plus de photons qu'ils n'en réémettent, diminuant ainsi le nombre de photons arrivant sur les cellules photovoltaïques. Cet effet est d'autant plus marqué pour des applications de longues durées.
De plus, la réémission isotrope de la lumière est diffuse. Cette réémission introduit un cône de fuite de la lumière par les faces externes du module photovoltaïque : une partie de la lumière réémise est perdue par les faces externes. Il y a donc une perte de flux lumineux arrivant finalement sur les cellules photovoltaïques du module.

Selon une alternative, il est proposé d'introduire les éléments de conversion spectrale au niveau des éléments de connexion des cellules photovoltaïques (WO 2011/082806).

Comme décrit dans la demande de brevet EP 2 372 786 et comme représenté sur la figure 1, il a aussi été proposé de disposer les éléments de conversion spectrale uniquement dans les espaces entre les cellules photovoltaïques du module.

Une telle solution n'est néanmoins pas tout à fait satisfaisante car, d'une part, la zone inter-cellules doit être suffisamment grande pour obtenir une modification significative du spectre solaire par les éléments de conversion spectrale, et, d'autre part, une partie importante du rayonnement émis est perdue à cause des cônes de fuite et de la discontinuité optique entre la zone entre les cellules et la face active de la cellule.

### Objet de l'invention

L'invention a pour but de remédier aux inconvénients de l'art antérieur et, en particulier, de proposer un module photovoltaïque permettant de limiter les phénomènes de cônes de fuite et d'obtenir un rendement de conversion amélioré, tout en étant facile à mettre en oeuvre, par un procédé de réalisation robuste et peu coûteux.

On tend vers ces objets par les revendications annexées.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente, de manière schématique, un module photovoltaïque selon l'art antérieur,
- la figure 2 représente, de manière schématique et en coupe, un module photovoltaïque selon un mode particulier de réalisation de l'invention,
- la figure 3 représente, de manière schématique et en vue de dessus, un module photovoltaïque selon un mode particulier de réalisation de l'invention,
- la figure 4 représente, de manière schématique et en coupe, une zone d'exclusion dans un module photovoltaïque,
- la figure 5 représente un graphique montrant le pourcentage de recouvrement de la face active de la cellule photovoltaïque par la zone d'exclusion en fonction de la largeur de l'espace inter-cellules,
- les figures 6 et 7 représentent, de manière schématique et en coupe, un module photovoltaïque selon différents modes particuliers de réalisation de l'invention,
- la figure 8 représente, de manière schématique et en coupe, une étape d'assemblage d'un module photovoltaïque selon un mode particulier de réalisation de l'invention,
- la figure 9 représente, de manière schématique et en coupe, un module photovoltaïque obtenu par pressage à chaud de l'assemblage selon la figure 7,
- la figure 10 représente, de manière schématique et en vue de dessus, un module photovoltaïque obtenu par pressage à chaud de l'assemblage selon la figure 7.

### Description d'un mode de réalisation préférentiel de l'invention

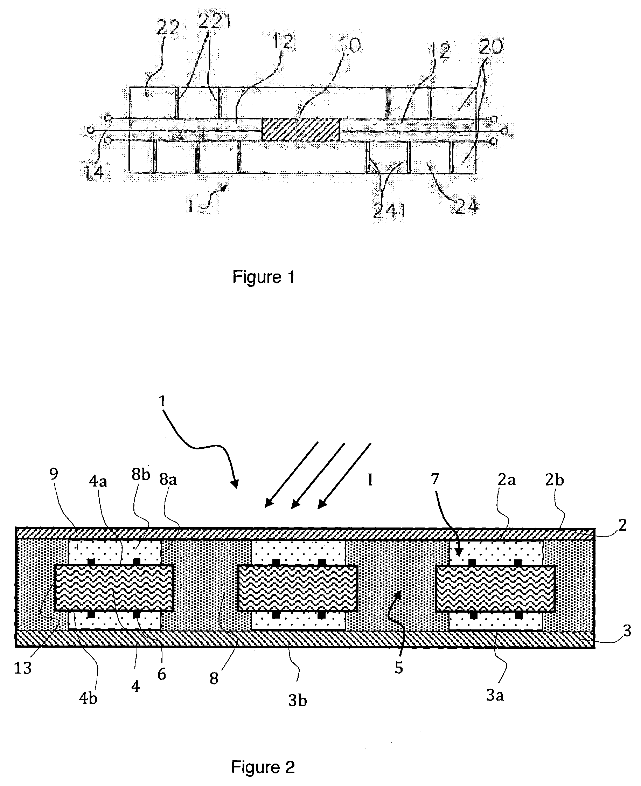

Comme illustré sur la figure 2, un module photovoltaïque 1, destiné à convertir un rayonnement électromagnétique incident I en énergie électrique, comporte en particulier :
- une plaque avant 2 et une plaque arrière 3, munies chacune respectivement d'une face interne 2a et 2b et d'une face externe 3a et 3b,
- au moins une cellule photovoltaïque 4 disposée entre les plaques avant 2 et arrière 3, munie d'au moins une face active 4a, c'est-à-dire une face capable de capter des photons des rayons lumineux incidents, arrivant sur ladite face 4a et de les transformer en électricité.

La plaque avant 2 du module est transparente aux rayonnements électromagnétiques incidents et notamment aux rayonnements solaires. Par plaque avant, on entend la plaque exposée au rayonnement électromagnétique incident I. Il s'agit par exemple de la plaque du module photovoltaïque exposée au soleil. La plaque avant 2 est avantageusement en verre ou en plastique.
La plaque arrière 3 peut aussi être transparente aux rayonnements électromagnétiques. Dans le cas d'un module bifacial, elle est par exemple en verre ou en plastique. Sinon, elle peut être en métal et/ou en polymère.

Le module photovoltaïque comporte, avantageusement, plusieurs cellules photovoltaïques 4. Les cellules photovoltaïques 4 sont, alors, de préférence coplanaires et séparées les unes des autres par des espaces inter-cellules 5. Les cellules photovoltaïques 4 peuvent être à base de silicium amorphe, monocristallin ou polycristallin ou encore à base de germanium. Il peut s'agir aussi de cellules organiques ou en couches minces inorganiques telles qu'une cellule à couche mince CIGS, CdTe, silicium amorphe ou semi-conducteur III/V. Les cellules photovoltaïques peuvent comporter une couche antireflet, en nitrure de silicium par exemple.
Chaque cellule photovoltaïque 4 comporte deux faces principales opposées 4a et 4b et au moins quatre faces latérales 13. Les faces latérales 13 prolongent ainsi les faces principales et sont sensiblement perpendiculaires auxdites faces principales. Les faces principales des cellules 4 sont, de préférence, parallèles aux plaques avant 2 et arrière 3 du module photovoltaïque 1. Au moins une des faces principales de la cellule photovoltaïque est une face active. Quand une seule des faces principales de la cellule photovoltaïque est active, il s'agit de la face exposée au rayonnement électromagnétique incident I, la face en regard de la plaque avant 2 transparente.

Le module comporte au moins un matériau d'encapsulation et, en particulier, au moins un matériau polymère d'encapsulation dans lequel sont noyées les cellules photovoltaïques 4. Par noyé, on entend que les cellules 4 sont enveloppées par le matériau encapsulant.
Le matériau encapsulant est aussi appelé encapsulant 7 ou milieu encapsulant ou encore milieu d'encapsulation. Il assure la cohésion mécanique du module une fois celui-ci assemblé.

Le milieu d'encapsulation est, préférentiellement, électriquement isolant. Il peut être formé d'une ou de plusieurs couches minces comprenant un matériau polymère. Préférentiellement, le matériau polymère est, par exemple, formé par au moins un polymère de type vinyl acétate. Avantageusement, il s'agit d'éthylène-acétate de vinyle (EVA). Il peut aussi être formé par un polymère du type polyvinyle de butyral (PVB), du type acétate de polyvinyle (PVA) ou tout autre polymère adapté. De plus, le matériau polymère est, avantageusement, au moins partiellement réticulé. Il peut s'agir aussi de silicone.

Le module photovoltaïque 1 comporte, en plus, un élément de conversion spectrale. L'élément de conversion spectrale comporte un matériau luminescent, apte à être excité par le rayonnement électromagnétique incident I. L'élément de conversion spectrale permet de modifier une partie du spectre du rayonnement électromagnétique incident I, notamment le spectre solaire.
En particulier, le matériau luminescent peut être fluorescent. Dans ce cas, la lumière réémise par le matériau excité peut être de même longueur d'onde ou de longueur d'onde plus grande ou plus petite que la lumière absorbée. Préférentiellement, la lumière réémise a une longueur d'onde supérieure à celle absorbée. En particulier, le matériau fluorescent est choisi parmi des colorants organiques, des azurants optiques, des microparticules ou des nanoparticules dopées en ions lanthanide, des complexes organo-lanthanides, des quantum-dots et leurs mélanges. Préférentiellement les nanoparticules sont des nanocristaux, les ions lanthanides sont, par exemple, des ions de cérium et/ou de l'erbium. Un oxyde YAG dopé au cerium ou des fluorures dopés à l'erbium peuvent aussi être utilisés. Les complexes organo-lanthanides sont des cristaux à base d'ions lanthanides sensibilisés par des ligands organiques. Avantageusement, les matériaux fluorescents utilisés ont un rendement quantique supérieur à 75% et ont une bonne résistance au photoblanchiment.
Le matériau luminescent peut aussi être choisi parmi les matériaux phosphorescents. Dans ce cas, la lumière absorbée sous illumination du rayonnement électromagnétique incident I peut être restituée, par exemple la nuit ou en présence nuageuse, et ainsi donner un signal exploitable si l'aire du matériau est suffisante. Préférentiellement, le matériau phosphorescent est choisi parmi la classe des aluminates dopés en ions de terre rare. Par exemple, il peut s'agir d'aluminate de strontium dopé europium de formule SrAl₂O₄:EU²⁺,Dy³⁺,B³⁺ ou encore d'aluminate de calcium de formule CaAl₂O_{4 :}Eu²⁺, Nd³⁺. Le matériau phosphorescent peut aussi être choisi parmi la classe des sulfures, notamment le ZnS:Cu⁺,Co²⁺ et le CaS ou encore parmi la classe des alumino-silicates, par exemple le MAl₂Si₂O₈:Eu²⁺ avec M=Ca,Sr,Ba. Ces matériaux peuvent, par exemple, être obtenu sous forme de poudres micrométriques ou par voie sol-gel.

Selon un mode de réalisation préférentiel, l'élément de conversion spectrale est formé par au moins une première zone de conversion spectrale 8, 8a, 8b disposée en regard d'une face latérale de la cellule photovoltaïque 4.
L'élément de conversion spectrale comporte une seconde zone de conversion spectrale prolongeant la première zone de conversion spectrale. Cette seconde zone de conversion spectrale est positionnée en bordure périphérique de la face active 4a de la cellule photovoltaïque 4, directement sur ladite face active 4a, de sorte que la partie de la face active 4a de la cellule photovoltaïque 4, recevant directement le rayonnement électromagnétique incident I, représente entre 40% et 90% de la surface totale de la face active 4a de la cellule photovoltaïque 4.
Par bordure périphérique de la face active, on entend le bord ou pourtour de la face active 4a de la cellule photovoltaïque 4. La seconde zone de conversion spectrale recouvre donc partiellement la face active 4a de la cellule photovoltaïque.

La zone 8 comprenant le matériau luminescent est également appelée zone photo-active ou zone luminescente.
Selon un mode de réalisation préférentiel, les zones de conversion spectrale 8 comportent une matrice, avantageusement formée par un matériau d'encapsulation et, en particulier en polymère, dans laquelle est dispersé le matériau luminescent. Le milieu d'encapsulation est, de préférence, transparent aux longueurs d'onde utiles aux matériaux luminescents.

Les zones photo-actives 8 disposées dans les espaces inter-cellules 5 permettent, avantageusement, d'utiliser les photons arrivant dans ces espaces. Les zones 8 luminescentes sont dans le même plan que les cellules 4.
Du fait des espaces inter-cellules 5 entre les cellules 4 adjacentes, les photons issus du rayonnement électromagnétique incident I tombant au niveau de ces espaces inter-cellules 5 n'interagissent en général pas avec les cellules 4, et ces photons sont, dans l'art antérieur, perdus.
Les photons qui seraient normalement perdus sont absorbés par les matériaux luminescents et réémis. Par un espace inter-cellules 5, on entend la région située entre deux cellules 4 adjacentes et coplanaires. Cette région a de préférence la même épaisseur que les cellules 4 et la même largeur.
De plus, avec les effets de guide d'onde latéraux, les photons réémis sont redirigés vers les faces actives 4a des cellules photovoltaïques 5. Tous les espaces inter-cellules 5 peuvent être occupés par les premières zones 8 ou seulement une partie des espaces inter-cellules 5. De plus, pour chaque espace inter-cellule 5, tout l'espace ou seulement une fraction de l'espace peut être rempli par une première zone 8.

Les zones photo-actives 8, placées sur les bords de la face active, sont disposées de sorte qu'au moins une zone 9 de transmission directe sépare la plaque transparente 2 de la cellule photovoltaïque 4. Cette zone 9 est configurée pour transmettre directement le rayonnement électromagnétique incident I depuis la plaque transparente 2 jusqu'à au moins 40% à 90% de la face active 4a de la cellule photovoltaïque 4. Un tel pourcentage permet avantageusement d'augmenter les performances optiques des cellules.
Selon un mode de réalisation préférentiel, la zone 9 de transmission directe est dépourvue d'élément de conversion spectrale, i.e. ne cette zone ne contient pas de matériau luminescent et elle est telle que le rayonnement électromagnétique incident I traverse le matériau polymère d'encapsulation sans que le rayonnement électromagnétique incident I ne soit ni réfléchi ni absorber par les matériaux luminescents.
La zone 9 peut être considérée comme une zone neutre optiquement, c'est-à-dire une zone non photo-active, exempte de matériaux luminescents.
La transmission du rayonnement électromagnétique incident I correspond plus particulièrement à la proportion du rayonnement électromagnétique incident I qui arrive jusqu'à la partie de la face active 4a, par exemple à travers les milieux encapsulants. Préférentiellement, la zone 9 neutre est une zone de très haute transmission (ou transmission directe), c'est-à-dire une zone ayant une proportion de rayonnement électromagnétique incident I arrivant sur la face active 4a supérieure à 90 % et, de préférence, proche de, voire égale à 100%. La zone 9 neutre est, avantageusement, constituée par le matériau polymère d'encapsulation utilisé pour former le milieu encapsulant 7 et elle assure, de part sa forme/nature, une transmission directe depuis la plaque transparente 2 jusqu'à la face active 4a de la cellule 4. Par transmission directe, on entend que le rayonnement électromagnétique incident I est directement transmis à la face active 4a de la cellule sans avoir été absorbé et réémis par les matériaux luminescents.

Une telle configuration permet d'avoir une continuité optique en périphérie de la cellule photovoltaïque 4 : il y a une continuité optique avec l'espace inter-cellules 4a de la cellule photovoltaïque 4, ce qui permet en plus d'assurer un transfert direct sans perte de la luminescence depuis la zone 8, 8a vers la face active 4a de la cellule 4. Les pertes lumineuses dues au cône de fuite sont ainsi réduites d'un facteur 2, par rapport à des configurations où les matériaux luminescents sont disposés uniquement dans les espaces inter-cellules, comme décrit dans l'art antérieur (EP 2 372 786).
Le matériau luminescent est présent continument depuis les espaces inter-cellules 5 jusqu'à la face active 4a des cellules photovoltaïques 4, ce qui permet, avantageusement, de réduire la taille desdits espaces inter-cellules 5 et ainsi d'augmenter le nombre de cellules 4 disposés dans le module et/ou les dimensions de leur surface active 4a par rapport à une configuration où seuls les espaces inter-cellules contiennent le convertisseur spectral.

De plus, à la différence de l'art antérieur (WO 2008/110567 et US 2009/0095341), l'élément de conversion spectrale est disposé de telle façon qu'au moins une zone 9 de transmission directe sépare la plaque transparente 2 de la cellule photovoltaïque 4.
La présence d'au moins une zone 9 neutre entre la plaque avant et la ou les cellules photovoltaïques 4 empêche ainsi la perte de flux lumineux arrivant sur la ou les faces actives 4a, dans un module photovoltaïque 1 comprenant un élément de conversion spectrale utilisant le phénomène de luminescence.

Selon un mode de réalisation préférentiel, le rapport entre l'indice optique de la zone de transmission directe 9 et l'indice optique des zones de conversion spectrale 8 est compris entre 0.9 et 1.2

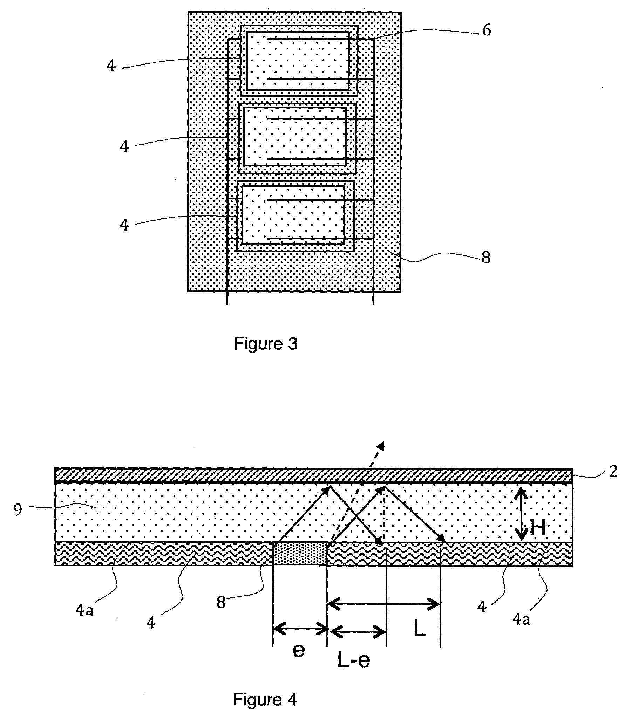

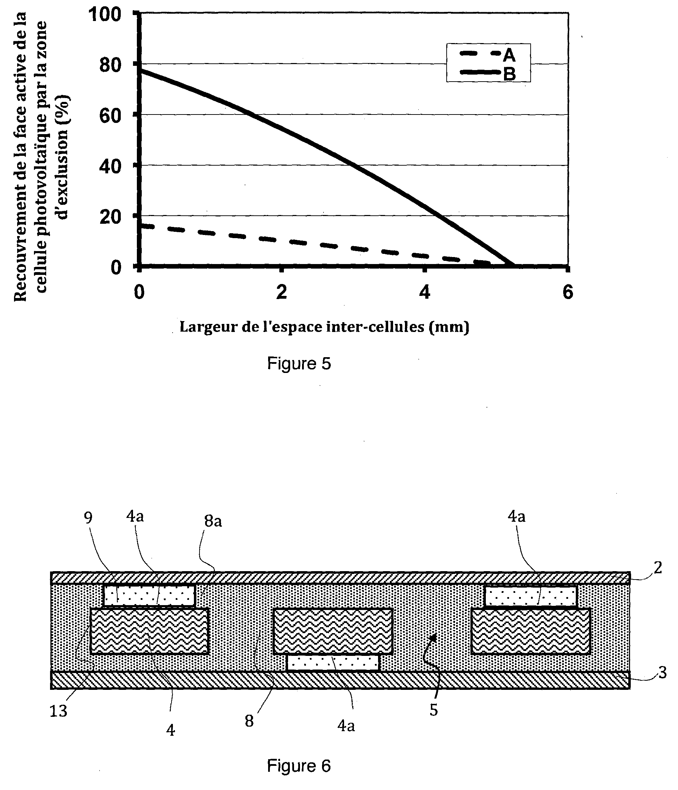

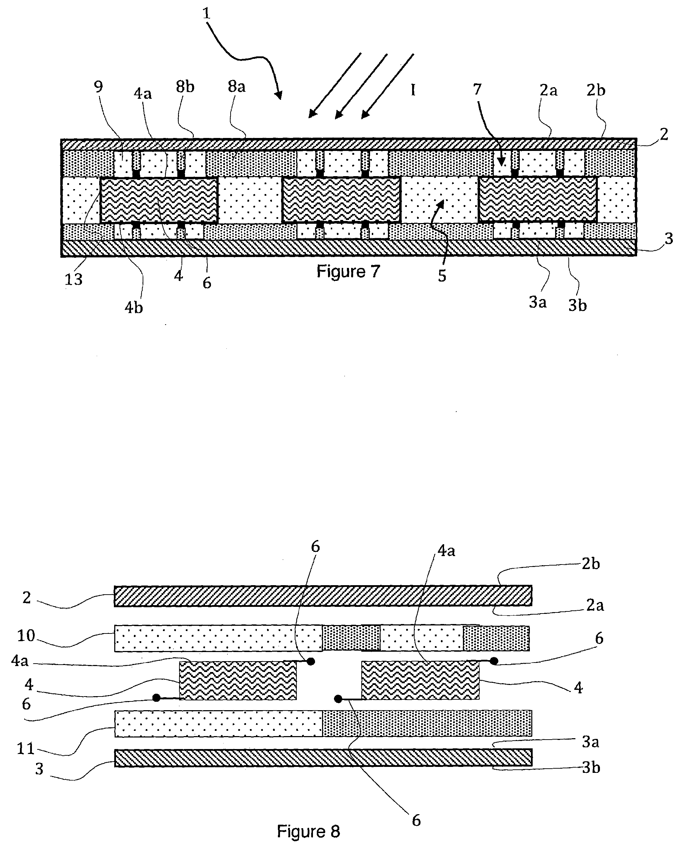

La figure 4 représente un module dont la demi-épaisseur H est H=4mm. L'indice de l'encapsulant et de la plaque avant 2 en verre sont proches de 1.5. La zone 8 contenant le convertisseur spectral est disposée uniquement entre deux cellules photovoltaïques 4, comme représenté sur la figure 7. Les cellules 4 sont séparées par un espace inter-cellules de largeur e.
L'angle critique au-dessus duquel un rayonnement électromagnétique, issu de l'espace inter-cellules 5, va être renvoyé en interne depuis la zone 8 photo-active vers la face active 4a de la cellule photovoltaïque 4 est θc=arcsin(1/1.5), soit 41°.
Il existe donc, dans le module photovoltaïque 1, une zone dite zone d'exclusion, de taille L-e, qui ne peut pas recevoir le rayonnement issu de la zone 8 si l'espace inter-cellules de largeur « e » est plus petit que L∼2Hsin(θc), soit 5.25mm.
Le graphique de la figure 5 représente le pourcentage de recouvrement de la face active 4a de la cellule photovoltaïque 4 par la zone d'exclusion en fonction de la largeur de l'espace inter-cellules 5.
Par exemple, pour un espacement inter-cellule de 2mm classiquement utilisé dans les modules photovoltaïques et pour une cellule photovoltaïque de 12,5cm de côté (courbe A), la zone d'exclusion correspond à 10% de la face active de la cellule photovoltaïque 4. Pour une cellule de 2cm de côté, la zone d'exclusion correspond à 55% de la face active 4a de la cellule 4 (courbe B).

La présence du convertisseur spectral sur les bords de la cellule permet donc avantageusement d'utiliser cette zone d'exclusion qui serait autrement perdue.
Les zones photo-actives 8 sont placées de sorte que la partie de la face active 4a de la cellule photovoltaïque 4, recevant directement le rayonnement électromagnétique incident I, représente avantageusement entre 40% et 90% de la surface totale de la face active 4a de la cellule photovoltaïque 4.

Le module photovoltaïque, précédemment décrit, est avantageusement un module de type bifacial, les cellules photovoltaïques possèdent deux faces actives 4a et 4b opposées.
Selon une alternative, il peut être de type monofacial. Dans ce cas, les zones photo-actives 8 sont avantageusement situées entre les cellules 4 et la plaque avant 2, tandis que l'espace entre les cellules 4 et la plaque arrière 3 est neutre.

Selon une autre alternative et comme représentée à la figure 6, les cellules photovoltaïques 4 peuvent avoir une seule face active 4a. Les cellules sont disposées de telle façon que les faces actives sont orientées alternativement et successivement vers la plaque avant 2 puis vers la plaque arrière 3, chaque face inactive étant recouverte totalement par le convertisseur spectral. Cette configuration est avantageuse dans le cas d'espaces inter-cellules 5 de faibles dimensions et de cellules photovoltaïques 4 de petites tailles car les bords des faces actives des cellules ne pourront pas toutes recevoir le rayonnement incident de façon optimale, du fait des contraintes géométriques.

Par ailleurs, le positionnement de la ou les zones 8 photo-actives à l'intérieur du module peut varier selon différents modes de réalisation. Ainsi, une zone neutre, sans matériau luminescent, sera maintenue entre la plaque avant 2 et chaque cellule 4, afin de permettre la transmission directe du rayonnement électromagnétique incident. Ceci permet d'éviter une perte de flux lumineux arrivant sur la face active 4a des cellules.

Selon un autre mode de réalisation préférentiel, comme représenté à la figure 7, les zones photo-actives 8 ne sont pas disposées dans les espaces inter-cellules 5, mais elles sont avantageusement séparées par les cellules photovoltaïques 4 et disposées de part et d'autres desdites cellules 4, entre celles-ci et les plaques avant 2 et arrière 3. En particulier, leur disposition est telle que les zones photo-actives 8a contenant les matériaux luminescents sont situées de part et d'autres et de chaque côté des espaces inter-cellules 5 et qu'elles recouvrent partiellement les cellules photovoltaïques 4, de préférence jusqu'à 60% de la surface active 4a de chacune des cellules 4.
Ceci permet alors de conserver au moins une zone non photo-active 9 entre au moins la plaque avant 2 et chacune des cellules photovoltaïque 4. Le rayonnement électromagnétique incident I est alors directement transmis par l'intermédiaire de cette zone 9 depuis la plaque avant 2 jusqu'à au moins une partie de la face active 4a de chaque cellule photovoltaïque 4.
Ainsi, les photons qui, sans la présence des zones photo-actives 8 seraient perdus ou inutilisés, sont absorbés par les éléments luminescents de la ou des zones 8 photo-actives et réémis pour être convertis par la cellule photovoltaïque 4 en électricité. De plus, la présence des zones neutres permet d'éviter une perte de flux arrivant sur la face active des cellules.

Par exemple, les photons peuvent être réémis à des longueurs d'onde où l'efficacité quantique de la cellule est meilleure : il peut s'agir de la convertir de l'ultraviolet en lumière rouge pour les cellules photovoltaïques 4 en silicium.
De plus, les matériaux luminescents réémettent de manière isotrope, ce qui permet de mieux piéger la lumière réémise au sein du module photovoltaïque 1.

La face active 4a de chaque cellule photovoltaïque peut être recouverte par une ou plusieurs zones photo-actives, sur les bords et/ou en son centre.

Par exemple, comme représenté sur la figure 7, les faces principales 4a et 4b, de chaque cellule photovoltaïque 4 peuvent être munies de pistes de contact électrique 6. Selon des modes particuliers de réalisation avantageux, des zones 8b photo-actives contenant les matériaux luminescents peuvent être disposées sur les pistes de contact 6. Chaque zone photo-active 8b est alors délimitée dans l'espace entre lesdites pistes de contact 6 et la plaque correspondante. Le positionnement des matériaux luminescents sur ces pistes de contact 6 est d'autant plus pertinent que les pistes de contact 6 des cellules 4 font normalement ombrage au rayonnement électromagnétique incident : il ne modifie en rien la quantité de rayonnement incident arrivant sur la face active 4a de la cellule 4 et il permet en plus de réémettre des photons qui seront convertis par la face active 4a de la cellule 4.

Pour réaliser un module photovoltaïque, tel que représenté sur la figure 2 par exemple, le procédé de réalisation comprend :
- la formation d'un assemblage comportant au moins la plaque transparente 2 et une plaque additionnelle 3 entre lesquelles sont placées la cellule photovoltaïque 4, l'élément de conversion spectrale, la zone de transmission directe 9, au moins un film d'encapsulation 10, avantageusement en matériau polymère, placé entre la plaque transparente 2 et la cellule photovoltaïque 4, l'élément de conversion spectrale étant disposé en regard d'une face latérale 13 de la cellule photovoltaïque 4 et entre la cellule photovoltaïque 4 et la plaque transparente 2, sur les bords de la face active 4a de la cellule photovoltaïque 4,
- le pressage à chaud dudit assemblage pour obtenir le module photovoltaïque.

Selon un mode de réalisation préférentiel, le film d'encapsulation 10 peut comporter au moins deux parties, l'une contenant le matériau luminescent et l'autre sans matériau luminescent et formant respectivement, après pressage à chaud, au moins les zones de conversion spectrale 8 et la zone de transmission directe 9.
De plus, un film d'encapsulation additionnel 12, avantageusement en matériau polymère, est placé lors de la formation de l'assemblage, en regard d'une face latérale 13 de la cellule photovoltaïque 4, ledit film d'encapsulation additionnel 12 comprenant le matériau luminescent sous forme dispersée.

Lors de l'assemblage, les plaques avant 2 et arrière 3 sont placées parallèlement l'une à l'autre, les films d'encapsulation 10 et 11 étant disposés respectivement en regard des faces internes 2a et 3a des plaques avant 2 et arrière 3. Les cellules photovoltaïques 4 sont disposées, de manière coplanaire, entre les plaques avant 2 et arrière 3 et, plus particulièrement, entre les deux films d'encapsulation 10 et 11.
Si le module comprend un film 12, celui-ci est disposé entre les cellules 4 afin de combler les espaces inter-cellules sur toute la largeur des cellules 4. Le film 12 a préférentiellement, une largeur égale à celle des plaques avant 2 et arrière 3 et à celle des films d'encapsulation 10 et 11.
Avantageusement, le film 12 entoure les cellules sur toute leur largeur.

Les films d'encapsulation 10 et 11 sont des films réalisés en un matériau polymère, apte à être laminé par pressage à chaud pour former l'encapsulant 7 du module photovoltaïque 1 dans lequel sont noyées les cellules 4.
Le ou les matériaux formant le premier film d'encapsulation 10 peuvent être identiques ou différents de ceux formant le deuxième film d'encapsulation 11. Ils sont, cependant, de préférence en matériau polymère. Un tel matériau polymère est aussi appelé matériau polymère d'encapsulation. Il est au moins partiellement réticulé avant l'assemblage du module et apte à être laminé. Avantageusement, les films d'encapsulation sont à base de polymère auto-porté de type vinyl-acétate. Par auto-porté, on entend un film pouvant se soutenir lui-même sans support nécessaire. De tels films peuvent exister, par exemple, sous forme de feuillets bruts, facilement manipulables.

Le film 12 est avantageusement un film à base de matériau polymère, de préférence apte à être laminé par pressage à chaud. En particulier, il peut être réalisé avec le même matériau polymère que les films d'encapsulation 10 et 11. Dans ce cas, il comporte néanmoins au moins un matériau luminescent dispersé de manière volumique et, préférentiellement, de manière homogène dans ledit matériau polymère. La zone 8 comporte ledit polymère d'encapsulation.
Le film 12 peut être obtenu par injection du matériau luminescent directement dans le matériau polymère composant ledit film.

Les matériaux luminescents peuvent être mélangés dans un matériau-hôte tel qu'un matériau polymère, notamment à base de silicone, une résine époxy ou des solutions liquides utilisées pour les dépôts sol-gel comme par exemple une solution contenant des alcoxydes de silicium. Avantageusement, les matériaux luminescents sont photostabilisés quand ils sont insérés dans un de ces matériaux-hôtes.
Par matériau-hôte, on entend un matériau pouvant être dopé, fonctionnalisé par les matériaux luminescents. Les matériaux luminescents sont, ainsi, insérés et dispersés dans le matériau-hôte de manière homogène.

Quelque soit les matériaux les formant, les films d'encapsulation 10, 11 et le film 12 contenant les matériaux luminescents sont parfaitement compatibles chimiquement, assurant ainsi une transition optique sans perte pour la lumière.

Un mélange limité des différents polymères peut éventuellement s'opérer aux interfaces, lors de l'étape suivante. L'indice de réfraction des films 10, 11 et 12 sont, de préférence, sensiblement les mêmes afin d'assurer une bonne continuité optique dans le module 1.

Chacun de ces films d'encapsulation 10 et 11 peut avoir été obtenu, par exemple, par assemblage de deux films initiaux distincts, l'un contenant des matériaux luminescents et l'autre n'en contenant pas. Ces deux films initiaux sont découpés pour former les différentes parties du film d'encapsulation final, une fois celles-ci assemblées. Un film, avec une alternance de zones contenant et ne contenant pas de matériau luminescent, est ainsi obtenu. Ces zones formeront après pressage à chaud au moins les zones 8 photo-actives et les zones 9 neutres.
Le procédé est simple à réaliser. En effet, il suffit de judicieusement découper les films polymères et de les assembler correctement avant l'étape d'assemblage des différents éléments du module et l'étape de pressage à chaud.

L'assemblage ainsi formé est ensuite pressé à chaud, par exemple dans un système de laminage, afin d'obtenir la cohésion dudit assemblage : les cellules photovoltaïques 4 sont alors mises en contact avec les films d'encapsulation 10 et 11 qui forment alors, avec le film 12, l'encapsulant 7 aussi appelé milieu d'encapsulation. De plus, les plaques avant 2 et arrière 3 entrent en contact chacune avec l'un des films d'encapsulation 10 et 11.
Préférentiellement, l'ensemble est pressé à chaud en appliquant une pression entre les deux plaques et sous une température généralement comprise entre 50°C et 200°C. Cette température dépend du matériau du film d'encapsulation utilisé, par exemple, pour l'EVA cette température est supérieure ou égale à 120°.

Lors de cette opération, le ou les matériaux polymères des films 10, 11 et 12 transitent avantageusement en phase visqueuse, afin d'épouser intimement la forme des cellules photovoltaïques tout en remplissant tous les espaces interstitiels.
Ce mode de réalisation est peu coûteux et simple à mettre en oeuvre, car il permet aisément de positionner les éléments luminescents, dispersés dans un matériau polymère, dans les espaces inter-cellules lors de l'assemblage du module 1.

Les éléments luminescents sont disposés de manière à laisser une zone neutre 9 interposée entre la plaque transparente 2 et la cellule photovoltaïque 4 et configurée pour transmettre directement le rayonnement électromagnétique incident I depuis la plaque transparente jusqu'à la face active de la cellule, entre 40% à 90% de la face active 4a de la cellule 4 recevant directement le rayonnement électromagnétique incident. La face active 4a de chaque cellule 4 reçoit donc plus de photons et le rendement de conversion est amélioré.
La zone 9 est, dans ce mode de réalisation, constituée par le film d'encapsulation 10 par exemple.

Selon un autre mode de réalisation particulier, le film d'encapsulation 10 peut comporter au moins une face dont une partie est recouverte d'une couche contenant au moins le matériau luminescent et formant, après pressage à chaud, les zones de conversion spectrale 8. Le dépôt du matériau luminescent peut aussi être réalisé en surface du film d'encapsulation 11.
Le dépôt peut être réalisé par voie sol-gel, par pulvérisation, par dépôt à la raclette également connu sous le nom anglo-saxon de « doctor-blading ». Un simple pinceau peut aussi être utilisé pour déposer les matériaux luminescents. Il peut servir à déposer une laque liquide ou une résine, chargée en matériaux luminescents, par exemple. La laque peut s'évaporer et laisser les matériaux luminescents en surface.
Ce sont des techniques de dépôt à bas coût.

Selon un autre mode de réalisation, les zones de conversion spectrale 8 sont formées par dépôt d'une couche 14 contenant au moins le matériau luminescent, sur une partie d'une face d'une des plaques transparente 2 ou additionnelle 3.
Ce dépôt est, avantageusement, réalisé sur une partie d'une des faces de la plaque avant 2, avant l'étape d'assemblage du module 1. Un même dépôt peut être en plus réalisé sur la plaque arrière 3, notamment dans le cas d'un module bifacial. De préférence, les dépôts sont réalisés sur les faces internes 2a et 3a des plaques avant 2 et arrière 3.

Selon un autre mode de réalisation, les pistes de contact 6 sont recouverte par une zone 8 contenant des éléments luminescents. Cette zone peut être, par exemple, réalisée par dépôt d'une couche le matériau luminescent. Il peut s'agir d'un dépôt au pinceau ou par pulvérisation (« spray » en anglais) sur les pistes de contact 6.

Les modes de réalisation précédemment décrits peuvent être utilisés séparément ou en combinaison les uns avec les autres. En effet, de nombreuses combinaisons sont possibles pour positionner les zones photo-actives et les zones neutres au sein du module photovoltaïque.

A titre de comparaison, la puissance électrique a été mesurée pour un module photovoltaïque 1 de type monofacial comprenant deux lignes indépendantes de trois cellules photovoltaïques 4 représentant deux configurations possibles dans un même module : l'une selon l'art antérieur, l'autre selon un mode particulier de réalisation de l'invention. Les cellules 4 d'une même ligne sont connectées électriquement en parallèle afin d'augmenter le courant de court-circuit ou de photogénération global du module. Les cellules sont des cellules en silicium cristallin, pré-découpées de quelques centimètres de largeur et d'une épaisseur de l'ordre de 200µm.

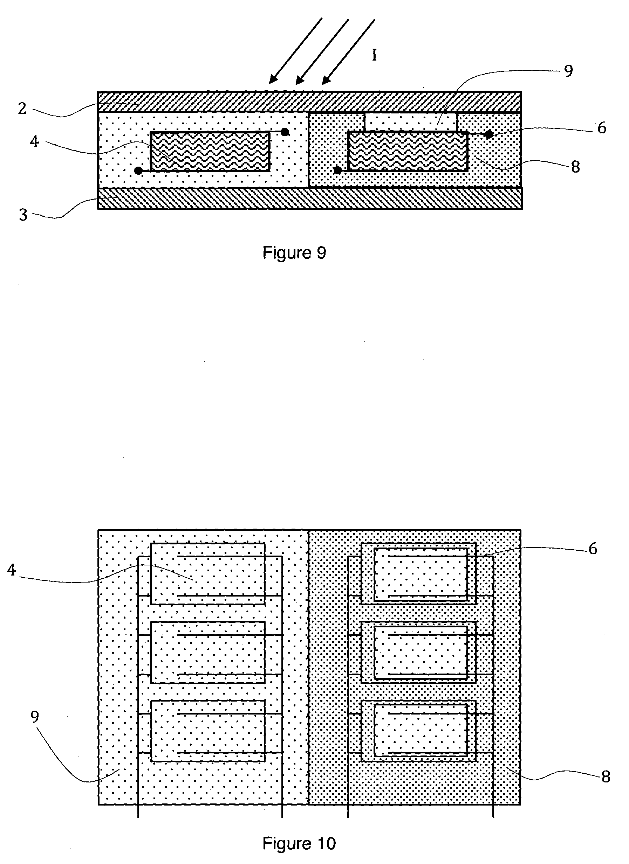

L'étape d'assemblage du module 1 est représentée schématiquement sur la figure 8. Seules deux cellules photovoltaïques 4 ont été représentées, chacune appartenant à une des deux lignes.
L'assemblage du module photovoltaïque a été réalisé à partir de l'empilement comprenant les éléments suivants : une plaque avant 2 en verre transparent, un premier film encapsulation 10, les deux lignes de cellules photovoltaïques 4, un second film d'encapsulation 11 et une plaque arrière 3, constituée par une feuille en plastique blanc. Les deux films d'encapsulation 10 et 11 sont à base de film polymère autoporté de type vinyl-acétate.
Pour la première ligne de cellules, représentée par la cellule à gauche sur les figures 8 et 9 et correspondant à la ligne de cellules à gauche sur la figure 10, les deux films d'encapsulation 10 et 11 ne contiennent pas de matériau luminescent.

Pour la seconde ligne de cellules représentée par la cellule à droite sur les figures 8 et 9 et correspondant à la ligne de cellules à droite sur la figure 10, au moins une partie des films d'encapsulation 10 et 11 contient des matériaux luminescents capables de convertir une part de l'ultraviolet en lumière rouge, avec un rendement quantique supérieur à 50%. Ainsi, pour cette partie, la totalité du film d'encapsulation disposée entre la plaque arrière 3 et les cellules 4 contient des matériaux luminescents dispersés de manière homogène dans tout le volume dudit film 11. Le film d'encapsulation 10, disposé lors de l'assemblage entre la plaque avant 2 et les cellules 4 de la deuxième ligne, contient des zones sans matériaux luminescents. Sur les figures 8, 9 et 10, les zones 8 avec matériau luminescent recouvrent les bords de la face active 4a des cellules photovoltaïques. Une zone 9 sans matériau luminescent est disposée au centre de la face active 4a de la cellule, permettant la transmission directe du rayonnement électromagnétique incident I.
Un tel film d'encapsulation 10 contenant des zones avec et sans matériaux luminescents peut avoir été obtenu, par exemple, par assemblage de deux films initiaux d'encapsulation, l'un contenant des matériaux luminescents et l'autre n'en contenant pas. Les deux films initiaux sont alors découpés et assemblés pour former différentes parties du film final d'encapsulation 10.

L'assemblage ainsi obtenu est ensuite pressé à chaud à 140°C pendant une dizaine de minutes dans un laminateur 3S sous une pression de 1 atmosphère afin d'obtenir le module 1 correspondant, comme représenté sur les figures 9 et 10.

Les rendements de conversion des deux lignes de cellules 4 ont alors été mesurés avant et après pressage à chaud.
Pour la première ligne de cellules, la puissance électrique maximum fournie augmente de 11,45% après pressage à chaud. Pour la deuxième ligne de cellules, la puissance électrique maximale augmente de 13,22% après pressage à chaud. Un gain différentiel relatif de +1,7% est alors obtenu pour les cellules entourées d'au moins une zone photo-active 8 contenant des matériaux luminescents après laminage par rapport aux cellules non entourées de matériaux luminescents. Lors de la réalisation du module photovoltaïque 1, le pressage à chaud permet aussi d'améliorer la puissance fournie.
La présence des premières zones 8 dans le module photovoltaïque 1 permet donc d'améliorer la puissance fournie par rapport à un module ne contenant pas de telles zones.

La présente invention est particulièrement pertinente pour des modules photovoltaïques ayant un coefficient de foisonnement cf (rapport entre la surface totale des cellules et la surface du module) sensiblement inférieur à 1 et, plus particulièrement, pour un coefficient de foisonnement compris entre 0,5 et 0,95. En effet, si le coefficient de foisonnement est proche de 1, i.e. les espaces entre les cellules sont très étroits, l'intérêt d'utiliser des matériaux luminescents dans lesdits espaces est alors réduit. Il faut augmenter la taille et/ou le nombre de ces espaces inter-cellules. Cependant, si le coefficient de foisonnement devient faible, la puissance électrique délivrée par le module photovoltaïque diminue aussi, mais cette diminution peut être en partie compensée par les effets de guide d'onde.
Avantageusement, de tels modules photovoltaïques permettent d'exploiter des effets de guide d'onde et plus particulièrement des effets de guide d'onde latéraux. Par guide d'onde latéral, on entend la réflexion interne d'un rayonnement électromagnétique dans le sens longitudinal du module photovoltaïque, le module étant en général planaire.

Des modules photovoltaïques tels que précédemment décrits présentent, l'avantage d'être plus faciles et moins coûteux à fabriquer que les modules nécessitant la présence de réflecteurs. Néanmoins, des matériaux luminescents peuvent être utilisés dans un module photovoltaïque muni d'un réflecteur en face arrière, pour augmenter la puissance générée par le module photovoltaïque.

Les modules photovoltaïques, contenant les éléments de conversion spectrale selon l'invention, présentent l'avantage de pouvoir être de type monofacial et bifacial. Ces dispositifs d'amplification optique sont peu coûteux et peuvent être élaborés à grande échelle. Ils trouveront de nombreuses applications et pourront servir, par exemple, en tant que modules photovoltaïques intégrés au bâtiment. Ainsi, les modules de type bifacial à faible coefficient de foisonnement peuvent être utilisés pour réaliser par exemple des verrières ou des fenêtres semi-transparentes à génération de puissance électrique. Le rayonnement incident traversant les espaces inter-cellules est exploité en partie sans compromettre pour autant le bon passage de la lumière vers le milieu situé derrière. La coloration due à la présence des matériaux luminescents ajoute en outre un aspect esthétique au module photovoltaïque.

L'invention n'est pas limitée aux modes de réalisation décrits ci-dessus.

En particulier, les modules photovoltaïques 1 décrits ci-dessus comportent une pluralité de cellules photovoltaïques 4, présentant des faces actives 4a coplanaires et séparées les unes des autres par des espaces inter-cellules 5.
Cependant, l'invention peut également s'appliquer à un module photovoltaïque ne contenant qu'une seule cellule photovoltaïque et à son procédé de réalisation.

De plus, le module photovoltaïque 1 peut être de tout type de forme. In peut être sous la forme d'un parallélépipède rectangle rigide mince, de quelques centimètres d'épaisseur. Il peut aussi être sous la forme d'une membrane souple et résistante. La longueur et la largeur dépendent des applications visées et seront choisies de manière appropriée. Le module photovoltaïque 1 peut être planaire ou courbé sous forme de tuile solaire.

De la même manière, les cellules photovoltaïques peuvent avoir différentes formes. Elles peuvent être rectangulaires, circulaires, carrées, tronquées, pleines ou percées, c'est-à-dire munies d'au moins un trou traversant.
Ainsi, pour des cellules percées, les zones photo-actives 8 peuvent être situées dans les trous de la cellule. De même, des cellules photovoltaïques en forme de pastille, c'est-à-dire sous forme de disque, peuvent être agencées en réseau et environnées des matériaux luminescents.
Ainsi, un large choix de forme de cellules photovoltaïques 4 peut être utilisé pour la réalisation des modules photovoltaïques 1.

Des plaques en verre transparent en face avant et/ou des films plastiques robustes en face arrière comprenant eux-mêmes les matériaux luminescents pourraient être utilisés, par exemple pour des modules souples.
Des verres de module sélectifs en longueur d'onde, comme des verres dichroïques, pourraient être en plus utilisés pour obtenir une meilleure sélection des longueurs d'onde du rayonnement incident.

Enfin, dans un mode particulier de réalisation, plusieurs matériaux luminescents pourraient être utilisés en cascade. Par exemple, un premier matériau luminescent dit « à conversion vers le bas » (ou à « down-conversion » en anglais) absorbe au moins une partie du rayonnement électromagnétique incident et réémet la lumière à des longueurs d'onde supérieures, c'est-à-dire à énergie plus basse. Cette lumière réémise peut alors être absorbée par un second matériau luminescent, qui réémet lui-même de la lumière à des longueurs supérieures. Préférentiellement, une telle cascade peut être utilisée pour, au début de la chaîne de matériaux luminescents, absorber dans l'ultra-violet, par exemple entre 350nm et 400nm, et à la fin de la chaîne réémettre dans l'infra-rouge, par exemple, avantageusement, entre 900nm et 1000nm pour les cellules Silicium.

## Revendications

1. Module photovoltaïque (1) pour convertir un rayonnement électromagnétique incident en énergie électrique (I), comprenant :
- au moins une plaque transparente (2) au rayonnement électromagnétique incident (I),
- au moins une cellule photovoltaïque (4) comprenant une face active (4a) disposée en regard de ladite plaque transparente (2),
- un élément de conversion spectrale comportant un matériau luminescent, apte à être excité par le rayonnement électromagnétique incident, et formé par au moins une première zone de conversion spectrale (8, 8a, 8b) disposée en regard d'une face latérale de la cellule photovoltaïque
- au moins une zone (9) de transmission directe, séparant la plaque transparente (2) de la cellule photovoltaïque (4), et configurée pour transmettre directement le rayonnement électromagnétique incident (I) depuis la plaque transparente (2) jusqu'à au moins une partie de la face active (4a) de la cellule photovoltaïque (4),
**caractérisé en ce que** l'élément de conversion spectrale comporte une seconde zone de conversion spectrale prolongeant la première zone de conversion spectrale, ladite seconde zone de conversion spectrale étant positionnée en bordure périphérique de la face active de la cellule photovoltaïque, directement sur ladite face active, de sorte que la partie de la face active (4a) de la cellule photovoltaïque (4), recevant directement le rayonnement électromagnétique incident (I), représente entre 40% et 90% de la surface totale de la face active (4a) de la cellule photovoltaïque (4).

2. Module photovoltaïque (1) selon la revendication 1, **caractérisé en ce que** le module photovoltaïque (1) comporte une pluralité de cellules photovoltaïques (4), coplanaires et séparées les unes des autres par des espaces inter-cellules (5) et **en ce que** chaque espace inter-cellule est occupé par une première zone de conversion spectrale.

3. Module photovoltaïque (1) selon l'une des revendications 1 et 2, **caractérisé en ce que** le coefficient de foisonnement est compris entre 0,5 et 0,95.

4. Module photovoltaïque (1) selon l'une quelconque des revendications 1 à 3 **caractérisé en ce que** le rapport entre l'indice optique de la zone de transmission directe (9) et l'indice optique des zones de conversion spectrale (8) est compris entre 0.9 et 1.2

5. Module photovoltaïque (1) selon l'une quelconque des revendications 1 à 4, **caractérisé en ce qu'**il comporte au moins un matériau d'encapsulation et en particulier au moins un matériau polymère d'encapsulation dans lequel est noyée la cellule photovoltaïque (4).

6. Module photovoltaïque (1) selon la revendication 5, **caractérisé en ce que** la zone de transmission directe (9) est constituée par le matériau d'encapsulation.

7. Module photovoltaïque (1) selon l'une des revendications 1 à 6, **caractérisé en ce que** les zones de conversion spectrale (8) comportent une matrice, avantageusement formée par un matériau d'encapsulation et, en particulier en polymère, dans laquelle est dispersé le matériau luminescent.

8. Module photovoltaïque (1) selon l'une quelconque des revendications 1 à 7, **caractérisé en ce que** le matériau luminescent est choisi parmi des colorants organiques, des azurants optiques, des microparticules ou des nanoparticules dopées en ions lanthanide, des complexes organo-lanthanides, des quantum-dots, des espèces phosphorescentes parmi lesquelles les aluminates dopés en ions de terre rare, des aluminates de calcium, des composés sulfurés, des alumino-silicates et leurs mélanges.

9. Procédé de fabrication d'un module photovoltaïque (1) selon l'une quelconque des revendications 1 à 8, **caractérisé en ce qu'**il comprend :
- la formation d'un assemblage comportant au moins la plaque transparente (2) et une plaque additionnelle (3) entre lesquelles sont placées la cellule photovoltaïque (4), l'élément de conversion spectrale, la zone de transmission directe (9), au moins un film d'encapsulation (10) avantageusement en matériau polymère placé entre la plaque transparente et la cellule photovoltaïque, l'élément de conversion spectrale étant disposé en regard d'une face latérale de la cellule photovoltaïque (4) et entre la cellule photovoltaïque (4) et la plaque transparente (2), sur les bords de la face active (4a) de la cellule photovoltaïque (4),
- le pressage à chaud dudit assemblage pour obtenir le module photovoltaïque.

10. Procédé de fabrication d'un module photovoltaïque (1) selon la revendication 9, **caractérisé en ce que** le film d'encapsulation (10) comporte au moins une face dont une partie est recouverte d'une couche contenant au moins le matériau luminescent et formant, après pressage à chaud, les zones de conversion spectrale (8).

11. Procédé de fabrication d'un module photovoltaïque (1) selon l'une des revendications 9 et 10, **caractérisé en ce que** les zones de conversion spectrale (8) sont formées par dépôt d'une couche (14) contenant au moins le matériau luminescent, sur une partie d'une face d'une des plaques transparente (2) ou additionnelle (3).

12. Procédé de fabrication d'un module photovoltaïque (1) selon l'une des revendications 9 à 11, **caractérisé en ce qu'**un film d'encapsulation additionnel (12), avantageusement en matériau polymère, est placé lors de la formation de l'assemblage, en regard d'une face latérale (13) de la cellule photovoltaïque (4), ledit film d'encapsulation additionnel (12) comprenant le matériau luminescent sous forme dispersée.

13. Procédé de fabrication d'un module photovoltaïque selon la revendication 9, **caractérisé en ce que** le film d'encapsulation (10) comporte au moins deux parties, l'une contenant le matériau luminescent et l'autre sans matériau luminescent et formant respectivement, après pressage à chaud, au moins les zones de conversion spectrale (8) et la zone de transmission directe (9).

## Patentansprüche

1. Photovoltaikmodul (1) zur Umwandlung von einfallender elektromagnetischer Strahlung (I) in elektrische Energie, bestehend aus:
- mindestens einer für die einfallende elektromagnetische Strahlung (1) transparenten Platte (2),
- mindestens einer photovoltaischen Zelle (4), die eine aktive Seite (4a) aufweist, die der genannten transparenten Platte (2) gegenüber angeordnet ist,
- einem Spektralumwandlungselement, welches ein lumineszierendes Material enthält, das geeignet ist, durch die einfallende elektromagnetische Strahlung angelegt zu werden, und welches von mindestens einem ersten Spektralumwandlungsbereich (8, 8a, 8b) gebildet wird, der gegenüber einer Seitenfläche der photovoltaischen Zelle angeordnet ist,
- mindestens einem Bereich (9) der Direktübertragung, der die transparente Platte (2) von der photovoltaischen Zelle (4) trennt, und der dazu konfiguriert ist, die einfallende elektromagnetische Strahlung (1) von der transparenten Platte (2) direkt an mindestens einen Teil der aktiven Seite (4a) der photovoltaischen Zelle (4) zu übertragen,
**dadurch gekennzeichnet,**
**dass** das Spektralumwandlungselement einen zweiten Spektralumwandlungsbereich in Verlängerung des ersten Spektralumwandlungsbereichs enthält, wobei dieser zweite Spektralumwandlungsbereich am Außenrand der aktiven Seite der photovoltaischen Zelle direkt auf der genannten aktiven Seite positioniert ist, so dass der Teil der aktiven Seite (4a), der die einfallende elektromagnetische Strahlung (1) direkt empfängt, zwischen 40 % und 90 % der Gesamtoberfläche der aktiven Seite (4a) der photovoltaischen Zelle (4) darstellt.

2. Photovoltaikmodul (1) nach Anspruch 1,
**dadurch gekennzeichnet,**
das das Photovoltaikmodul (1) eine Mehrzahl von photovoltaischen Zellen (4) enthält, die koplanar und voneinander durch Zellenzwischenräume (5) getrennt sind, und dass jeder Zellenzwischenraum von einem ersten Spektralumwandlungsbereich eingenommen wird.

3. Photovoltaikmodul (1) nach einem der Ansprüche 1 und 2,
**dadurch gekennzeichet,**
**dass** der Flächenwirkungsgrad zwischen 0,5 und 0,95 liegt

4. Photovoltaikmodul (1) nach einem der Ansprüche 1 bis 3,
**dadurch gekennzeichnet,**
**dass** das Verhältnis zwischen dem Brechungsindex des Bereichs der Direktübertragung (9) und dem Brechungsindex der Spektralumwandlungsbereiche (8) zwischen 0,9 und 1,2 liegt.

5. Photovoltaikmodul (1) nach einem der Ansprüche 1 bis 4,
**dadurch gehennzeichnet,**
**dass** es mindestens ein Kapselungsmaterial und insbesondere mindestens ein polymeres Kapselungsmaterial enthält, in das die photovoltaische Zelle (4) eingebettet ist.

6. Photovoltaikmodul (1) nach Anspruch 5,
**dadurch gekennzeichnet,**
**dass** der Bereich der Direktübertragung (9) aus dem Kapselungsmatarial besteht.

7. Photovoltaikmodul (1) nach einem der Ansprüche 1 bis 6,
**dadurch gekennzeichnet,**
**dass** die Spektralumwandlungsbereiche (8) eine Matrize enthalten, die vorteilhafterweise aus einem Kapselungsmaterial und insbesondere aus einem Polymer gebildet ist, und in der das lumineszierende Material verteilt ist.

8. Photovoltaikmodul (1) nach einem der Ansprüche 1 bis 7,
**dadurch gekennzeichnet,**
**dass** das lumineszierende Material gewählt wird unter organischen Farbstoffen, optischen Aufhellern, mit Lanthanid-Ionen dotierten Mikropartikeln oder Nanopartikeln, organolanthanoiden Komplexen, Quantendots, phosphoreszierenden Materialarten, darunter mit Ionen Seltener Erden dotierte Aluminate, Kaziumaluminate, schwefelhaltigen Verwindungen, Aluminiumsilikaten und ihren Gemischen.

9. Verfahren zur Herstellung eines Photovoltaikmoduls (1) nach einem der Ansprüche 1 bis 8,
**dadurch gekennzeichnet,**
**dass** es umfasst:
- die Bildung einer Gesamtanordnung, die mindestens die transparente Platte (2) und eine zusätzliche Platte (3) aufweist, zwischen denen die photovoltaische Zelle (4), das Spektralumwandlungselement, der Bereich der Direktübertragung (9), mindestens eine vorteilhafterweise aus Polymer bestehende Kapselungsschicht (10) zwischen der transparenten Platte und der photovoltaischen Zelle angeordnet werden, wobei das Spektralumwandlungselement gegenüber einer Seitenfläche der photovoltaischen Zelle (4) und zwischen der photovoltaischen Zelle (4) und der transparenten Platte (2) an den Rändern der aktiven Seite (4a) der photovoltaischen Zelle (4) angeordnet ist,
- das Warmpressen dieser Gesamtanordnung, um das Photovoltaikmodul zu erhalten.

10. Verfahren zur Herstellung eines Photovoltaikmoduls (1) nach Anspruch 9,
**dadurch gekennzeichnet,**
**dass** die Kapselungsschicht (10) mindestens eine Seite aufweist, von der ein Teil mit einer Beschichtung überzogen ist, die mindestens das lumineszierende Material enthält und nach dem Warmpressen die Spektralumwandlungsbereiche (8) bildet.

11. Verfahren zur Herstellung eines Photovoltaikmoduls (1) nach einem der Ansprüche 9 und 10,
**dadurch gekennzeichnet,**
**dass** die Spektralumwandlungsbereiche (8) durch Aufbringen einer Beschichtung (14), die mindestens das lumineszierende Material enthält, auf einem Teil einer Seite der transparenten Platte (2) oder der zusätzlichen Platte (3) gebildet werden.

12. Verfahren zur Herstellung eines Photovoltaikmoduls (1) nach einem der Ansprüche 9 bis 11,
**dadurch gekennzeichnet,**
**dass** eine zusätzliche Kapselungsschicht (12), vorteilhafterweise aus Polymermaterial, bei der Bildung der Gesamtanordnung gegenüber einer Seitenfläche (13) der photovoltaischen Zelle (4) angeordnet wird, wobei diese zusätzliche Kapselungsschicht (12) das lumineszierende Material in verteilter Form enthält.

13. Verfahren zur Herstellung eines Photovoltaikmoduls nach Anspruch 9,
**dadurch gekennzeichnet,**
das die Kapselungsschicht (10) mindestens zwei Teile enthält, wobei der eine das lumineszierende Material enthält und der andere ohne lumineszierendes Material bleibt und diese nach dem Warmpressen mindestens den Spektralumwandlungsbereich (8) bzw. den Bereich der Direktübertragung (9) bilden.

## Claims

1. A photovoltaic module (1) to convert an incident electromagnetic radiation into electric power (I), comprising:
- at least one plate (2) transparent to the incident electromagnetic radiation (I),
- at least one photovoltaic cell (4) comprising an active face (4a) arranged facing said transparent plate (2),
- a spectral conversion element comprising a luminescent material designed to be excited by the incident electromagnetic radiation and formed by at least one first spectral conversion area (8, 8a, 8b) arranged facing a lateral face of the photovoltaic cell,
- at least one direct transmission area (9) separating the transparent plate (2) from the photovoltaic cell (4), and configured to transmit the incident electromagnetic radiation (I) directly from the transparent plate (2) to at least a part of the active face (4a) of the photovoltaic cell (4),
**characterized in that** the spectral conversion element comprises a second spectral conversion area extending the first spectral conversion area, said second spectral conversion area being positioned on the peripheral edge of the active face of the photovoltaic cell, directly on said active face, so that the part of the active face (4a) of the photovoltaic cell (4) directly receiving the incident electromagnetic radiation (I) represents between 40% and 90% of the total surface of the active face (4a) of the photovoltaic cell (4).

2. The photovoltaic module (1) according to claim 1, **characterized in that** the photovoltaic module (1) comprises a plurality of coplanar photovoltaic cells (4) separated from one another by inter-cell spaces (5) and **in that** each inter-cell space is occupied by a first spectral conversion area.

3. The photovoltaic module (1) according to one of claims 1 and 2, **characterized in that** the cell packing factor is comprised between 0.5 and 0.95.

4. The photovoltaic module (1) according to any one of claims 1 to 3, **characterized in that** the ratio between the optical index of the direct transmission area (9) and the optical index of the spectral conversion areas (8) is comprised between 0.9 and 1.2.

5. The photovoltaic module (1) according to any one of claims 1 to 4, **characterized in that** it comprises at least one encapsulation material and in particular at least one polymer encapsulation material in which the photovoltaic cell (4) is sunk.

6. The photovoltaic module (1) according to claim 5, **characterized in that** the direct transmission area (9) is formed by the encapsulation material.

7. The photovoltaic module (1) according to one of claims 1 to 6, **characterized in that** the spectral conversion areas (8) comprise a matrix advantageously formed by an encapsulation material, in particular made from polymer, in which the luminescent material is dispersed.

8. The photovoltaic module (1) according to any one of claims 1 to 7, **characterized in that** the luminescent material is chosen from organic colorants, optical brighteners, microparticles or nanoparticles doped with lanthanide ions, organo-lanthanide complexes, quantum dots, phosphorescent species among which aluminates doped with rare earth ions, calcium aluminates, sulphide compounds, alumino-silicates and mixtures of the latter.

9. A method for producing a photovoltaic module (1) according to any one of claims 1 to 8, **characterized in that** it comprises:
- formation of an assembly comprising at least the transparent plate (2) and an additional plate (3) between which there are placed the photovoltaic cell (4), the spectral conversion element, the direct transmission area (9), at least one encapsulation film (10) advantageously made from polymer material placed between the transparent plate and the photovoltaic cell, the spectral conversion element being arranged facing a lateral face of the photovoltaic cell (4) and between the photovoltaic cell (4) and the transparent plate (2), on the edges of the active face (4a) of the photovoltaic cell (4),
- hot pressing of said assembly to obtain the photovoltaic module.

10. The method for producing a photovoltaic module (1) according to claim 9. **characterized in that** the encapsulation film (10) comprises at least one face a part of which is covered by a layer containing at least the luminescent material and forming the spectral conversion areas (8), after hot pressing.

11. The method for producing a photovoltaic module (1) according to one of claims 9 and 10, **characterized in that** the spectral conversion areas (8) are formed by deposition of a layer (14) containing at least the luminescent material on a part of the face of one of the transparent (2) or additional (3) plates.

12. The method for producing a photovoltaic module (1) according to one of claims 9 to 11, **characterized in that** an additional encapsulation film (12), advantageously made from polymer material, is placed, when formation of the assembly is performed, facing a lateral face (13) of the photovoltaic cell (4), said additional encapsulation film (12) comprising the luminescent material in dispersed form.

13. The method for producing a photovoltaic module according to claim 9, **characterized in that** the encapsulation film (10) comprises at least two parts, one containing the luminescent material and the other without any luminescent material and respectively forming, after hot pressing, at least the spectral conversion areas (8) and the direct transmission area (9).
